(19) **Europäisches Patentamt**

**European Patent Office**

**Office européen des brevets**

(11) **EP 0 910 110 B1**

(12) **EUROPÄISCHE PATENTSCHRIFT**

(45) Veröffentlichungstag und Bekanntmachung des Hinweises auf die Patenterteilung:
**01.06.2005 Patentblatt 2005/22**

(51) Int Cl.$^7$: **H01J 37/305**, H01J 37/302

(21) Anmeldenummer: **98119063.0**

(22) Anmeldetag: **08.10.1998**

(54) **Verfahren für den Betrieb eines Hochleistungs-Elektronenstrahls**

Method for operating a high power electron beam

Procédé de commande d'un faisceau d'électrons de grande puissance

(84) Benannte Vertragsstaaten:
**BE DE FR GB**

(30) Priorität: **16.10.1997 DE 19745771**

(43) Veröffentlichungstag der Anmeldung:
**21.04.1999 Patentblatt 1999/16**

(73) Patentinhaber: **Unaxis Deutschland Holding GmbH**
**63450 Hanau (DE)**

(72) Erfinder:
• **Bähr, Martin, Dr.rer. nat**
**91729 Haundorf-Gräfensteinberg (DE)**
• **Laux, Erik, Dipl.-Ing.**
**63526 Erlensee (DE)**

(74) Vertreter: **Schickedanz, Willi, Dr. Dipl.-Ing.**
**Langener Strasse 68**
**63073 Offenbach (DE)**

(56) Entgegenhaltungen:
EP-A- 0 368 037     DE-A- 3 538 857
US-A- 3 582 529     US-A- 4 380 703
US-A- 5 346 554     US-A- 5 483 077

## Beschreibung

Metalle und Metallegierungen von hoher Qualität können mittels eines Elektronenstrahlschmelzprozesses hergestellt werden. Die Verwendung einer Elektronenstrahlkanone als Wärmequelle zum Schmelzen von Metallen und Legierungen hat den Vorteil, daß sehr komplexe Schmelzprozesse realisiert werden können, weil der Elektronenstrahl ablenkbar ist und damit verschiedene Orte auf der Oberfläche eines Metallblocks oder einer Metallschmelze erreichen kann. Mit Hilfe der Elektronenstrahltechnik kann nahezu jedes Material effektiv verdampft werden. Die Verdampfungsrate ist hierbei etwa um den Faktor 100 größer als beim Sputterprozeß. Außer den Standardprozessen mit Aluminium sind insbesondere Materialien mit hohem Schmelzpunkt und hoher Verdampfungstemperatur für die Elektronenstrahlverdampfungstechnik von Interesse. Zu diesen Materialien zählen beispielsweise Cr, Co, Ni, Ta, W, Legierungen oder Oxide wie $SiO_2$, $Al_2O_3$, $ZrO_2$, MgO. Auch für die reaktive Verdampfung, z. B. $Al + O_2 \rightarrow Al_2O_3$ stellt die Elektronenstrahl-Technologie die erforderlichen stabilen und gleichmäßigen Verdampfungsraten bereit.

Ein besonders wichtiges Anwendungsgebiet der Elektronenstrahlverdampfung stellt die Beschichtung großer Flächen mit verschiedenen Materialien dar, beispielsweise die Beschichtung von Magnetbändern mit CoNi-Legierungen oder die Beschichtung von Folien für die Nahrungsmittelverpackung (vgl. hierzu DE 42 03 632 A1 = US-A-5 302 208).

Ein weiteres Anwendungsgebiet ist die korrosionsverhindernde Beschichtung von Turbinenschaufeln, wo z. B. eine 100 bis 200 μm dicke Schicht aus MCrAlY aufgebracht und eine zusätzliche wärmedämmende Schicht von 100 bis 200 μm Yttrium bzw. stabilisiertes $ZrO_2$ hinzugefügt wird, damit die Lebensdauer der Turbinenflügel erhöht wird.

Der Hauptvorteil der Elektronenstrahlbeschichtung liegt in der hohen Leistungsdichte im Brennpunkt des Elektronenstrahls, die bis zu 1 MW/cm$^2$ betragen kann. Aufgrund dieser hohen Leistungsdichte ergibt sich eine hohe Oberflächentemperatur, so daß auch Materialien mit einem hohen Schmelzpunkt verdampft werden können. Üblicherweise ist die Brennpunktfläche kleiner als 1 cm$^2$, so daß nur kleine Verdampfungszonen erzeugt werden. Ist deshalb der Elektronenstrahl stationär oder ist seine Geschwindigkeit, mit welcher er die zu verdampfende Oberfläche abtastet, zu gering, geht der größte Teil der Elektronenstrahlenergie in die Tiefe des Materials, was nicht zu einer besseren Verdampfung beiträgt.

Die Leistungsverteilung auf der zu verdampfenden Oberfläche kann mit modernen Hilfsmitteln geregelt werden, wodurch die Schichtdicke des aufgedampften Materials z. B. auf einfache Weise dadurch optimiert werden kann, daß das Muster der Strahlabtastung geändert wird.

Die mittels Elektronenstrahlverdampfung aufgebrachten Schichten sind oft weniger dicht als die vergleichbaren gesputterten Schichten, und auch die Eigenschaften der Schichten können verschieden sein. Um die Eigenschaften der mittels Elektronenstrahlverdampfung aufgebrachten Schichten zu verbessern, kann während des Aufdampfverfahrens eine zusätzliche Plasma-Unterstützung hinzugefügt werden.

Aufgrund der Wechselwirkung des Elektronenstrahls mit den Restgas-Partikeln dürfen der Druck in einer Beschichtungskammer und der Abstand zwischen der Elektronenstrahlkanone und dem zu verdampfenden Material, d. h. die Strahllänge, einen vorgegebenen Wert nicht übersteigen. Bei Beschleunigungsspannungen von 20 bis 50 kV darf z. B. der Druck nicht größer als 10$^{-2}$ mbar sein. Die Länge des Elektronenstrahls sollte 1 m nicht übersteigen. Sind höhere Drücke oder längere Elektronenstrahlen erforderlich, sollte die Beschleunigungsspannung erhöht werden.

Ein Druckanstieg bei höheren Leistungspegeln kann auch durch die Abschirmwirkung von Materialverunreinigungen verursacht sein, z. B. durch $H_2O$ oder Kristallwasser. Außerdem lösen sich einige Oxide teilweise in Metall und Sauerstoff auf. Der Druckanstieg kann die Schichteigenschaften verändern oder den Elektronenstrahl defokussieren. Die Verdampfungsmaterialien sollten deshalb hinsichtlich der Abschirmwirkung von Verunreinigungen und Wasser optimiert werden.

Elektronenstrahlkanonen mit einer Leistung von bis zu 1000 kW und mit Beschleunigungsspannungen bis zu 160 kV sind verfügbar. Für Beschichtungszwecke werden üblicherweise Elektronenstrahlkanonen mit 150 bis 300 kW und 35 kV Beschleunigungsspannung verwendet. Die Elektronenstrahlablenkung und -fokussierung wird in der Regel mittels Magnetspulen durchgeführt. Sowohl die Strahlfokussierung als auch die Strahlablenkung können leicht durch Verändern der in der Magnetspule fließenden Ströme gesteuert werden.

Im allgemeinen werden beim Elektronenstrahlschweißen Abtastfrequenzen von mehr als 10 kHz verwendet. Dagegen liegt die bei Beschichtungsanwendungen übliche Frequenz bei 100 bis 1000 Hz, wobei sich diese Frequenz auf die Grundfrequenz bezieht. Sind Oberwellen vorhanden, werden Frequenzen von z. B. 10 kHz ebenfalls einbezogen. Unter Abtastfrequenz wird die Frequenz verstanden, mit welcher sich ein Elektronenstrahl z. B. zwischen zwei Punkten auf der Oberfläche eines Tiegels hin- und herbewegt.

Bei der Steuerung eines Hochleistungs-Elektronenstrahls sind im wesentlichen folgende Aspekte zu beachten: die Leistungsversorgung der Kanone, die Führung des Elektronenstrahls innerhalb der Kanone und die Führung des Elektronenstrahls über die Prozeßflächen.

Es sind bereits mehrere Verfahren zur Steuerung eines Leistungs-Elektronenstrahls bekannt, bei denen ein besonderes Ablenksystem (DE 42 08 484 A1) mit Sensoren zum Erfassen des Auftreffpunkts des Elektronenstrahls auf einer Schmelze (EP 0 184 680, DE 39 02 274 C2) vorgesehen sind. Auch Ablenksysteme mit mehr als einem Elektronenstrahl (US-A-4 988 844) oder Elektronenstrahl-Positionsregelungen mit Magnetfeldsensoren (DE 35 32 888 C2) wurden bereits vorgeschlagen.

Bei einem anderen bekannten Verfahren zur Steuerung der Verdampfungsratenverteilung eines Elektronenstrahls wird der Verdampferfläche ein Steuergrößenraster für mindestens einen Betriebsparameter des Elektronenstrahls zugeordnet (EP 0 368 037 A1). Mit dem Gegenstand des Anspruchs 1 hat dieses Verfahren gemeinsam, dass die Strahlenpositionen des Elektronenstrahls ausgewählt und Korrekturgrößen gebildet werden. Außerdem wird der Elektronenstrahl mit einer vorgebbaren Geschwindigkeit und einer bestimmten Intensität über wenigstens einen Punkt der Oberfläche des zu verdampfenden oder zu schmelzenden Materials geführt.

Es ist auch eine Einrichtung für die Eingabe eines Sollwerts für den Auftreffpunkt eines Elektronenstrahls auf ein Medium bekannt, bei welcher die Konturen eines Tiegels mittels des Teach-In-Verfahrens ermittelt werden (DE 35 38 857 A1). Hierbei wird bei der Erfassung der Konturen der Elektronenstrahl manuell in die Tiegelecken gelenkt und mittels einer Recheneinrichtung durch lineare Interpolation zwischen den einzelnen Eckpositionen die Gesamtkontur ermittelt. Nach Eingabe der Sollpositionen werden mit der jeweils zugeordneten Verweildauer die Sollpositionen durchlaufen, wobei die den Ortskoordinaten der Sollpositionen zugeordneten Stromwerte einer magnetischen Ablenkeinheit korrigiert werden.

Weiterhin ist auch noch eine mittels eines Mikroprozessors durchgeführte Steuerung eines Hochleistungselektronenstrahls bekannt, bei welcher eine herkömmliche Hardware mit einer Software betrieben wird, die für eine gleichmäßige Strahl-Dispersion und große Flexibilität bei der Realisierung von Schmelzanweisungen bzw. -rezepten ausgelegt ist (M. Blum, A. Choudhury, F. Hugo, F. Knell, H. Scholz, M. Bähr: Application of a New Fast EB-Gun Control System for Complex Melting Processes, EB-Conference, Reno/USA, October 11 - 13, 1995). Die wesentlichen Merkmale der hochfrequent gesteuerten Elektronenstrahlanlage sind eine Thermokamera und eine Meßeinrichtung für die Elementenkonzentration in der Gasphase. Diese Steueranlage ist vielfältig verwendbar, z. B. beim Titanherdschmelzen oder beim Tantal-Tropfenschmelzen. Sie ist außerdem für die gleichzeitige Steuerung von mehreren Schmelzöfen geeignet, die mit bis zu fünf Elektronenstrahlkanonen ausgerüstet sein können. Mit ihr ist es außerdem möglich, einen Elektronenstrahl-Prozeß mit genau definierter Oberflächen-Temperaturverteilung sogar bei unsymmetrischen Schmelzanordnungen zu realisieren, z. B. beim horizontalen Tropfenschmelzen, wo auf einer Seite das zu schmelzende Material über einen wassergekühlten Kupfertrog zugeführt wird, oder bei einer anderen Elektronenstrahl-Anordnung, wo sich auf einer Seite aufgrund des überfließenden Schmelzguts eine hohe Eingabeenergie ergibt. Die Steuerung erfolgt auch bei dieser bekannten Anordnung mittels eines herkömmlichen PC, der über eine auf WINDOWS basierende Software betrieben wird.

Bei einer Weiterentwicklung der vorstehend beschriebenen Steuerung eines Hochleistungselektronenstrahls kommt ein Elektronenstrahlabtast- und -steuersystem zum Einsatz, mit dem die Elektronenstrahl-Abtastgeschwindigkeit direkt gesteuert wird (M. Bähr, G. Hoffmann, R. Ludwig, G. Steiniger: New Scan and Control System (ESCOSYS™) for High Power Elektron Beam Techniques, Fifth International Conference On Plasma, Surface Engineering, Garmisch-Partenkirchen, September 1996). Dieses Regelsystem, das auf der sogenannten "Eigenintelligenz" beruht, weist zwei wesentliche Merkmale auf. Das eine Merkmal betrifft die Fehlerkompensation. Hierbei wird das Verhalten des Elektronenstrahls zunächst "eingelernt", wobei man auf einem Bildschirm bei geringer Leistung beginnt. Nach diesem "Einlern-Vorgang" werden die Frequenzdämpfungs- und Ablenkungsfehler der Elektronenstrahlkanone automatisch kompensiert. Ein kreisförmiges Muster des Strahls bleibt dabei ein Kreis - und nicht etwa eine Ellipse - im Tiegel, und zwar bei verschiedenen Einfallswinkeln. Die Größe dieses Kreises bleibt selbst dann gleich, wenn die Abtastfrequenz geändert wird. Die Ablenkfehlerkompensation erfolgt durch Anwendung einer 2 x n-dimensionalen Polynomfunktion. Die Frequenzdämpfung wird hinsichtlich Amplituden- und Phasendrehung durch Anwendung des Schnellen-Fourier-Algorithmus kompensiert. Es werden somit nicht nur geometrische Muster genau kompensiert, sondern auch sehr komplexe Muster. Trotzdem arbeitet das System mit einer Frequenzbegrenzung von 10 kHz, was Zyklus-Frequenzen bis zu 1 kHz ermöglicht. Dies minimiert die Notwendigkeit einer Frequenzdämpfungskompensation. Neben der erwähnten Fehlerkompensation ist die direkte Eingabe der Leistungskompensation für eine bestimmte Oberfläche wesentlich. Mit dem bekannten System lassen sich Aufdampfschichten von großer Gleichmäßigkeit bei großer Geschwindigkeit erzielen. Beispielsweise ist bei einem reaktiven $Al_2O_3$-Prozeß eine Beschichtungsgeschwindigkeit von 10 m/s möglich. Nähere Einzelheiten darüber, wie die erwähnte Ablenkfehlerkompensation bzw. Frequenzdämpfungskompensation erreicht werden, wurden in dem erwähnten Vortrag nicht angegeben.

Ausgehend von dem vorstehend beschriebenen Stand der Technik ist es Aufgabe der Erfindung, ein Vefahren zu schaffen, mit dem es möglich ist, den Elektronenstrahl automatisch und fehlerkompensiert bei vorgegebenen Abtast- oder Leistungsmustern abzulenken.

Diese Aufgabe wird gemäß den Merkmalen des Patentanspruchs 1 gelöst.

Der mit der Erfindung erzielte Vorteil besteht insbesondere darin, daß die geometrische Bahn des Elektronenstrahls bzw. die von ihm hervorgerufene Leistungsverteilung auf der vorgegebenen Schmelzfläche fehlerkorrigiert frei wählbar ist. Der Anwender muß auftretende Fehler nicht mehr berücksichtigen und kann direkt in Ortskoordinaten die Eingabe durchführen. Außerdem kann er eine Leistungsverteilung direkt definieren und muß nicht, wie bisher, die Leistungsverteilung erst durch eine geeignete Kombination von geometrischen Ablenkmustern über Versuche ermitteln. Weiterhin ist es mit der Erfindung möglich, einen geschlossenen Regelkreis zu verwenden. Wird z. B. bei einem Verdampfungsprozeß in-situ die Verdampfungsrate gemessen und daraus über einen Regelalgorithmus eine neue Leistungsverteilung generiert, beispielsweise um eine sehr gleichförmige Beschichtung zu erzielen, so kann ein solcher Regelkreis sehr präzise nachregeln, wenn vorher eine Fehlerkorrektur durchgeführt wurde. Werden diese Fehler nicht korrigiert, verbleiben auch bei einem geschlossenen Regelkreis Restfehler.

Beim Schmelzen kann mit Hilfe der Erfindung z. B. auch die Temperaturverteilung auf einen Tiegel oder Ingot gesteuert oder geregelt werden, wenn ein entsprechendes Meßsystem vorliegt. Hierdurch können Materialstrukturen und unerwünschte Verdampfungsverluste von Legierungsbestandteilen besser optimiert werden.

Bei der Erfindung handelt es sich um ein passives System, d. h. es wird keine Messung des Auftreffpunkts des Elektronenstrahls auf dem zu schmelzenden Material vorgenommen. Vielmehr kennt das System die Auftreffpunkte durch ein einmaliges, zu Beginn des Schmelzvorgangs durchgeführtes Erkennen ("teach-in"). Die Erfindung kann allerdings auch mit automatischen Meßsystemen kombiniert werden, welche die Auftreffpunkte des Elektronenstrahls direkt messen. Bei der Realisierung des passiven Systems wird zunächst ein Ablenkmuster in Ortskoordinaten definiert bzw. berechnet und in einem Speicher zwischengespeichert. Die Ablenkgeschwindigkeit des Elektronenstrahls errechnet sich aus einer vorgegebenen Ablenkfrequenz des Elektronenstrahls und den Strecken zwischen den definierten Punkten auf der Oberfläche des zu schmelzenden Materials. Ein spezieller Algorithmus, der insbesondere einen Fehlerkorrektor-Algorithmus enthält, transformiert dann das in Ortskoordinaten definierte Ablenkmuster in ein solches Ablenkmuster, das in Stromwerten für die Ablenkspulen definiert ist. Auch hier ergibt sich die Ablenkgeschwindigkeit aus der zusätzlich angegebenen Frequenz. Das so erhaltene Strommuster kann dann direkt auf einen Stromverstärker gegeben werden, der die magnetische Ablenkspule treibt und damit den Elektronenstrahl magnetisch ablenkt. Die durch Wirbelstromverluste entstehenden frequenzabhängigen Dämpfungen und die frequenzabhängigen nichtlinearen Verzerrungen im Stromverstärker sowie jede andere Nichtlinearität im Frequenzgang zwischen Impulsausgabe und Elektronenstrahl wird hierbei berücksichtigt.

Ein Ausführungsbeispiel der Erfindung ist in der Zeichnung dargestellt und wird im folgenden näher beschrieben. Es zeigen:

Fig. 1 eine Prinzipdarstellung einer Elektronenstrahlschmelz- oder Elektronenstrahl-Verdampfungsvorrichtung mit ablenkbarem Elektronenstrahl;

Fig. 2 einen Schmelztiegel, über dessen Oberfläche ein ablenkbarer Elektronenstrahl geführt wird;

Fig. 3 eine Rasterplatte, die zwecks Kalibrierung über einem Tiegel angeordnet ist;

Fig. 4 eine graphische Darstellung der realen x-, y-Stromkomponente, um ein vorgegebenes Muster zu realisieren;

Fig. 5 eine schematische Darstellung zur Erläuterung des wachsenden Ablenkfehlers eines Elektronenstrahls bei zunehmender Ablenkfrequenz;

Fig. 6 eine Darstellung der Frequenzdämpfungskompensation, bei welcher mit zunehmender Frequenz die Stromamplituden in radialer und tangentialer Richtung erhöht werden;

Fig. 6a das Frequenzspektrum der x- und y-Stromkomponenten eines korrigierten Ablenkstromverlaufs;

Fig. 7 eine Prinzipdarstellung einer Anordnung, bei eine statische und dynamische Korrektur von Ablenkfehlern vorgenommen wird;

Fig. 8 eine vorgegebene Leistungsverteilung bei einem Rechtecktiegel;

Fig. 9 den Elektronenstrahl-Weg bei einer Leistungsverteilung gemäß Fig. 8;

Fig. 10 eine vorgegebene Leistungsverteilung bei einem runden Tiegel;

Fig. 11 den Elektronenstrahl-Weg bei einer Leistungsverteilung gemäß Fig. 10;

Fig. 12 eine Prinzipdarstellung einer erfindungsgemäßen Ansteuerung von zwei Elektronenstrahlkanonen;

Fig. 13 eine Prinzipdarstellung eines geschlossenen Regelsystems;

Fig. 14 eine geometrische Darstellung der verschiedenen erfindungsgemäßen Verfahrenswege.

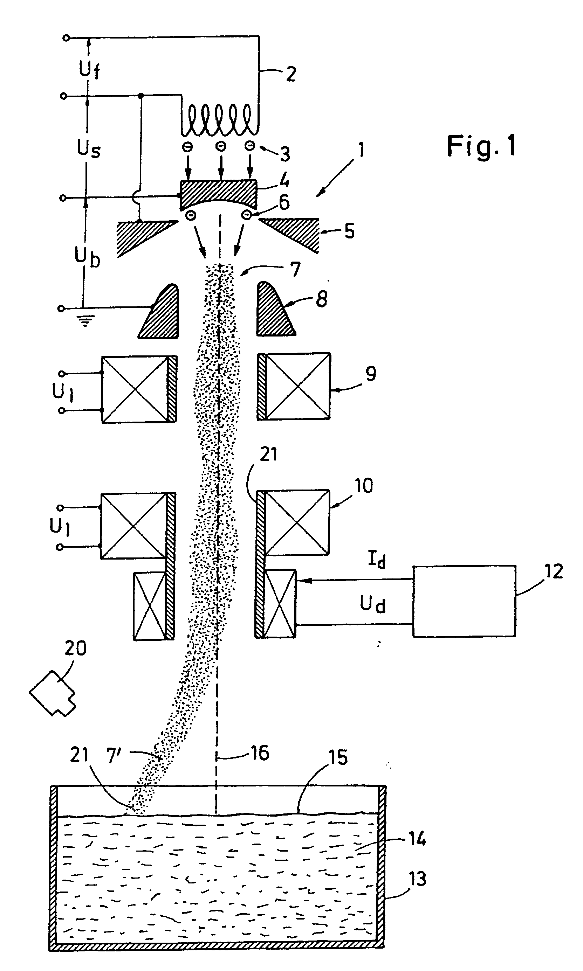

In der Fig. 1 ist das Prinzip einer Hochleistungs-Elektronenstrahlkanone 1 dargestellt. Mit 2 ist ein Heizfaden bezeichnet, der an einer Spannung $U_f$ liegt und Elektronen 3 aussendet. Unterhalb des Heizfadens 2 ist eine feste und meist blockförmige Kathode 4 angeordnet. Diese wird über einen Elektronenstrom soweit aufgeheizt, daß dieser Block 4 seinerseits Elektronen 6 emittiert. Zwischen dem Block 4 und einer Anode 8 liegt eine Hochspannung $U_b$ an, durch welche die Elektronen 6 beschleunigt werden. Ein Wehneltzylinder 5 beeinflußt das elektrostatische Feld in der Weise, daß die Elektronen in eine Bohrung der Anode 8 fokussiert werden und damit ein gebündelter Elektronenstrahl 7 erzeugt wird. Mittels magnetischer Linsen 9, 10 wird dieser Elektronenstrahl weiter gebündelt. Mit 11 ist eine magnetische Ablenkeinheit bezeichnet, die mit einem Strom $I_d$ versorgt wird, welche aus der Spannungsquelle 12 kommt. Diese Spannungsquelle 12 kann Gleichstrom oder Wechselstrom liefern, wobei die Amplitude und/oder Frequenz des Stroms veränderbar ist.

4

Unterhalb der Elektronenstrahlkanone 1 ist ein Tiegel 13 im Querschnitt dargestellt, in dem sich Metall bzw. eine Metall-Legierung 14 befindet. Auf die Oberfläche 15 dieses Metalls 14 trifft der abgelenkte Elektronenstrahl 7', der in der Fig. 1 einen Ablenkungswinkel $\alpha$ gegenüber der horizontalen Achse 16 aufweist.

Mit 20 ist eine Thermokamera bezeichnet, mit deren Hilfe es möglich ist, die Temperaturverteilung auf der Oberfläche 15 des Metalls 14 zu erfassen.

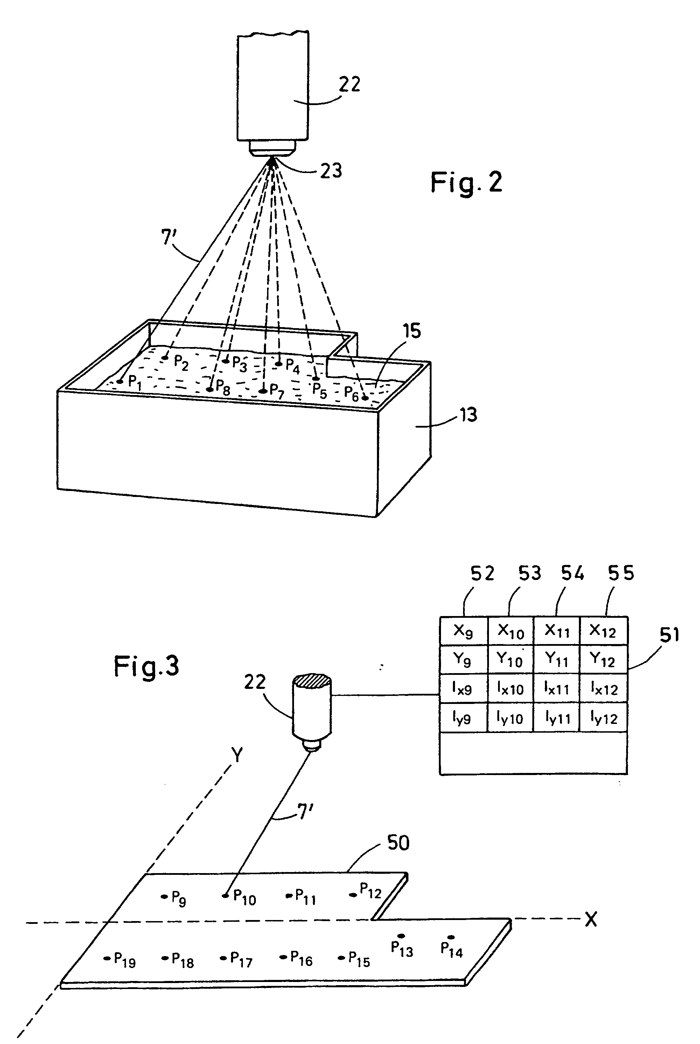

In der Fig. 2 ist nur der untere Teil 22 der Elektronenstrahlkanone 1 dargestellt, wobei die Ablenkeinheit 11 nicht gesondert dargestellt ist; sie befindet sich in dem Teil 22. Der Tiegel 13 und die Metalloberfläche 15 sind perspektivisch dargestellt.

Man erkennt hierbei, daß der Elektronenstrahl 7', der hier nur als Linie dargestellt ist, in der Weise abgelenkt werden kann, daß er die ganze Oberfläche 15 überstreicht. Einzelne Auftreffpunkte des Elektronenstrahls 7' auf der Oberfläche 15 sind mit $P_1$ bis $P_8$ bezeichnet.

Die Auftreffpunkte $P_1$ bis $P_8$ können mit Hilfe von x,y-Koordinaten oder Polarkoordinaten auf der Oberfläche 15 definiert werden. Wird die Länge des Elektronenstrahls 7' bei der Festlegung der Punktkoordinaten einbezogen, bieten sich Kugelkoordinaten an. Hierbei legt etwa der Abstand 23 - $P_1$ den Abstand des Elektronenstrahls vom Austritt aus der Elektronenstrahlkanone bis zum Punkt $P_1$ fest, während ein erster nicht dargestellter Winkel $\alpha$ die Abweichung des Strahls von der Mittenachse und ein zweiter, ebenfalls nicht dargestellter Winkel $\beta$ den Drehwinkel - etwa im Uhrzeigersinn - bezeichnen. Wie aus der Technik der Fernsehröhre bekannt, kann ein Elektronenstrahl zu einem bestimmten Punkt abgelenkt werden, wenn durch die x,y-Ablenkspulen bestimmte Ströme fließen. Es besteht also eine eindeutige Zuordnung zwischen den Strömen durch die x-,y-Ablenkspulen und dem Auftreffpunkt des Elektronenstrahls 7'.

Diese feste Zuordnung von Raumkoordinaten und idealen Stromkoordinaten stimmt indessen nur bei einem stationär abgelenkten Elektronenstrahl 7', d. h. wenn sich der Elektronenstrahl 7' nicht bewegt und wenn keine Störgrößen auftreten. Wird die Elektronenstrahlkanone etwa schräg zum Tiegel 13 aufgestellt oder treten z. B. am Tiegel 13 zusätzliche magnetische oder elektrische Störfelder auf, kann der Elektronenstrahl 7' selbst dann nicht zu den vorgegebenen Punkten $P_1$ bis $P_8$ gelangen, wenn seine Ablenkeinheiten mit den zugeordneten Strömen beschickt werden, die diesen Punkten bei idealen Verhältnissen zugeordnet sind. In der Regel wird aber bei Verdampfungsprozessen die Elektronenstrahlkanone nicht rechtwinklig und mittig zum Tiegel positioniert, sondern seitlich schräg zum Tiegel, um eine Innenbeschädigung des Kanonentubus zu minimieren. Dadurch wird beispielsweise ein quadratisches Ablenkmuster auf der Oberfläche 15 in ein gebogenes trapezförmiges Ablenkmuster verzerrt oder ein als Kreis eingegebenes Ablenkmuster wird zu einer Ellipse. Um trotzdem auf dem zu verdampfenden Material ein Quadrat oder bzw. einen Kreis zu erzeugen, müssen folglich an den idealen Stromparametern Korrekturen vorgenommen werden, d. h. die Ablenkeinheiten dürfen nicht mit den gleichen Strömen beschickt werden wie im Fall einer exakt symmetrischen Ausrichtung des Elektronenstrahls und bei rein induktiven Ablenkeinheiten.

Die Intensität des Elektronenstrahls 7' ist bei dem hier beschriebenen Verdampfungsverfahren stets konstant bzw. nur langsam veränderbar. Die durch den Elektronenstrahl 7' in die Oberfläche 15 eingebrachte Leistung wird durch die Geschwindigkeit bestimmt, mit der er sich von einem Punkt zum nächsten bewegt. Beispielsweise spricht man auch von der Verweildauer des Elektronenstrahls auf einem Punkt der Oberfläche, weil der Strahl nicht exakt punktförmig ist und somit mit seinem Durchmesser für eine bestimmte Zeit auf einem Punkt verweilt.

Um den vorstehend erwähnten statischen Ablenkfehler zu ermitteln und seinen Einfluß zu eliminieren, müssen die Abweichungen der tatsächlichen Ablenkung von einer idealen Ablenkung festgestellt werden. Die ideale Ablenkung läßt sich rechnerisch leicht ermitteln, nicht jedoch die tatsächliche Ablenkung. Diese wird deshalb mittels eines Einlernverfahrens festgestellt.

Die Fig. 3 zeigt eine Skizze zur Erläuterung des Einlernvorgangs (teach-in) für eine Korrektur von Ablenkfehlern. Derartige Ablenkfehler können - wie bereits erwähnt - durch eine Schiefstellung der Elektronenkanone relativ zur zentralen Tiegelachse oder durch zusätzliche Magnetfelder am Tiegel hervorgerufen werden. Die Korrektur von solchen Ablenkfehlern wird auch statische Korrektur genannt, weil sie auch bei sich nicht bewegendem Elektronenstrahl vorgenommen werden muß. Die Elektronenstrahlkanone 22 und der Elektronenstrahl 7' sind in der Fig. 3 nur angedeutet. Wesentlich für den Einlern- oder Teach-in-Vorgang ist ein Markierungsblech 50, das über einem nicht dargestellten Tiegel angeordnet ist und die Markierungspunkte $P_9$ bis $P_{19}$ aufweist. Diese Markierungspunkte werden mittels des Elektronenstrahls 7' manuell und einzeln durch Verändern der Ablenkströme angefahren. Nimmt der Elektronenstrahl 7' die in der Fig. 3 dargestellte Position ein, werden die für $P_{10}$ bekannten Ortskoordinaten $x_{10}$, $y_{10}$ in einem Speicher 51 abgelegt. Diesen Ortskoordinaten sind Stromkoordinaten $I_{x10}$, $I_{y10}$ zugeordnet, d. h. Ströme der x- und y-Ablenkung, die bewirken, daß der Elektronenstrahl 7' die in der Fig. 3 gezeigte Position einnimmt. Es handelt sich hierbei um tatsächlich fließende Ströme, die von den idealen Strömen, die einer x-,y-Koordinate zugeordnet sind, abweichen und bereits eine Fehlerkorrektur beinhalten. Die Amplituden der tatsächlich fließenden Ströme $I_{x10}$, $I_{y10}$, die notwendig sind, um einen vorgegebenen Punkt anzusteuern, werden ebenfalls im Speicher 51 abgelegt und der Ortskoordinaten von $P_{10}$ zugeordnet. In gleicher Weise wird nun bezüglich der Ortskoordinaten $P_9$, $P_{11}$ bis $P_{19}$ verfahren, so daß letztendlich im Speicher jeder Punkt $P_9$ bis $P_{19}$ bestimmten Ablenkströmen $I_{x9}$, $I_{y9}$...$I_{x19}$, $I_{y19}$ zugeordnet

ist. Will man nun erreichen, daß der Elektronenstrahl trotz der vorhandenen Störgrößen exakt die Punkte $P_9$ bis $P_{19}$ trifft, braucht man nur die diesen Punkten zugeordneten und durch das Einlernverfahren ermittelten Stromamplituden auf die entsprechenden x-,y-Ablenkeinheiten zu geben. Obgleich beim Einlernvorgang als Ablenkungsströme vorzugsweise Gleichströme verwendet werden, gelten die ermittelten Korrekturfaktoren auch für die Amplituden von Wechselströmen.

Durch die Zuordnung der räumlichen x, y-Koordinaten zu den jeweiligen Stromkoordinaten wird gewissermaßen eine Transformation vom Ortsraum der Metalloberfläche in den Stromraum der Ablenkspulen vorgenommen. Bei diesen Stronakoordinaten handelt es sich, wie bereits erwähnt, um die tatsächlichen Stromamplituden, die fließen müssen, damit der Elektronenstrahl einen vorgegebenen x,y-Punkt ansteuert. Es wäre jedoch auch möglich, jedem x, y-Punkt eine ideale Stromkoordinate zuzuordnen und dieser wiederum einen Korrekturfaktor, der durch $I_{ideal}/I_{tatsächlich}$ ausgedrückt werden könnte.

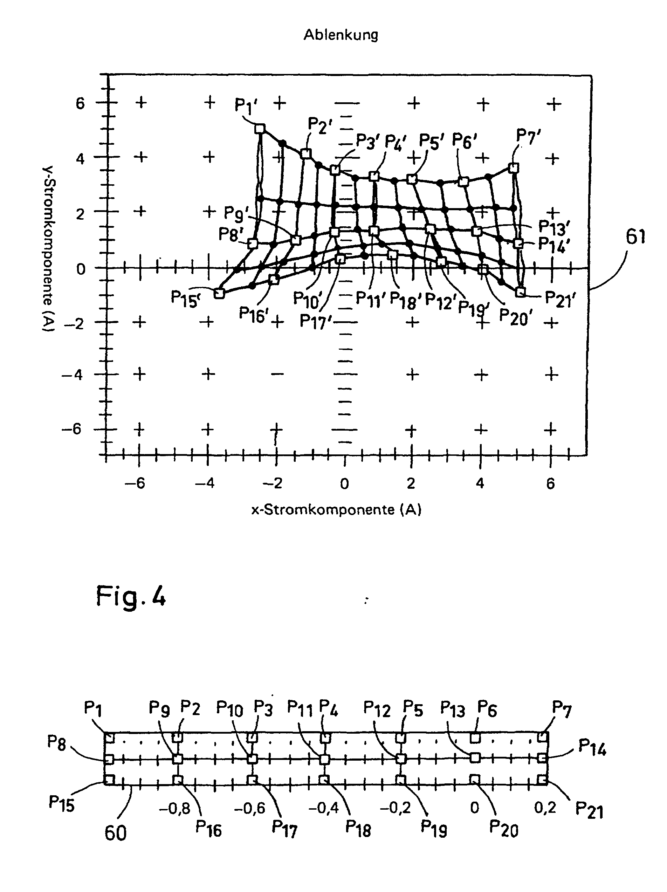

In der Fig. 4 ist das Ergebnis des Einlernvorgangs für einen Rechtecktiegel 60 dargestellt. Man erkennt hierbei einen Tiegel 60 mit den Punkten $P_1$ bis $P_{22}$, die exakt angesteuert werden sollen. Um diese Ansteuerung mittels eines Elektronenstrahls zu erreichen, der den erwähnten statischen Ablenkfehlern unterworfen ist, müssen die Ströme für die x- bzw. y-Koordinaten Größen haben, die bei 61 dargestellt sind. Diese durch die Punkte $P_1'$ bis $P_{22}'$ gekennzeichneten Ströme sind korrigiert und liegen nicht auf einem Rechteck, sondern auf einem verzerrten Trapez.

Die Ablenkspulen müssen mit den bei 61 dargestellten korrigierten Stromamplituden beaufschlagt werden, damit der Elektronenstrahl letztendlich auf den Punkten $P_1$ ... $P_{22}$ des Tiegels auftrifft.

Die beim Tiegel 60 gezeigte Punktrasterung, die für das Teach-in-Verfahren ausreichend ist, ist für den Betrieb indessen relativ grob. Um auch für die Zwischenbereiche die Ablenkspulen mit den richtigen Strömen zu beaufschlagen, können Interpolationsverfahren verwendet werden. Eine besonders geeignete Methode, eine größere Punktdichte als in Fig. 4 bei 60 gezeigt zu erhalten, besteht in der Methode der kleinsten Fehlerquadrate. Bei dieser Methode wird für n Meßwertpaare $x_i$, $y_i$ ein Ausgleichspolynom

$$y = \sum_{i=0}^{n} a_i x^i$$

bestimmt. Als Ausgleichskriterium dient die Summe der Abweichungsquadrate der einzelnen Meßpunkte vom Ausgleichspolynom, die minimal werden soll (H. Frohner, E. Ueckert: Grundlagen der elektrischen Meßtechnik, 1984, S. 208, 209). Es werden bei diesem Ausgleichsverfahren die jeweiligen Ströme - d. h. auch die Ströme für die Zwischenpositionen zwischen den Punkten $P_1$ ... $P_{22}$ - über die Gleichung

$$\text{Stromamplitude}_k = \sum_{i,j=0}^{n} a_{i,j,k} \cdot (\text{Ortskoordinate } x)^i \cdot (\text{Ortskoordinate } y)^j$$

ermittelt, wobei

$k$ = x', y' und

$a_{i,j,k}$ = die Koeffizienten, die im Rahmen der Einlernprozedur an den Punkten $P_1$ . . . $P_{22}$ ermittelt wurden,

Um die vorstehend erwähnten Fehler für alle Koordinaten zu korrigieren, werden somit die Ablenkfehler über ein zweidimensionales Polynom n-ter Ordnung berechnet, d. h. über dieses Polynom läßt sich die Stromamplitude ($I_x$, $I_y$) für jeden beliebigen Punkt (x, y) in einer Ebene berechnen.

Durch dieses Verfahren werden auch die nicht während des Teach-in-Verfahrens gemessenen Orte vom Ortsraum in den Stromraum transformiert.

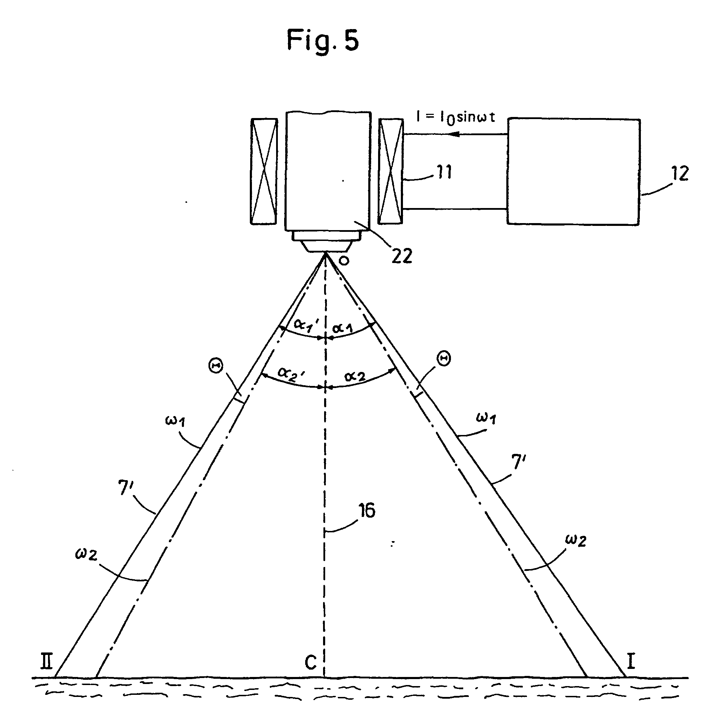

Nachdem die statische Ablenkkorrektur durchgeführt wurde, wird eine dynamische Frequenzkorrektur vorgenommen, d. h. aus einem rein sinusförmigen Wechselstrom, der die Ablenkspulen beaufschlagt, wird ein korrigierter Wechselstrom ermittelt. Diese Wechselstromkorrektur ist erforderlich, weil im praktischen Betrieb Frequenzfehler auftreten. Worum es sich bei den Frequenzfehlern handelt, wird im folgenden anhand der Fig. 5 beschrieben.

In der Fig. 5, die eine eindimensionale Bewegung eines Elektronenstrahls zeigt, ist eine rein sinusförmige Ablenkung des Elektronenstrahls 7' dargestellt. Hierbei wird die Ablenkung des Elektronenstrahls 7' durch die Amplitude und die Frequenz des durch die Ablenkeinheit fließenden Stroms $I = I_o \sin\omega t$ bestimmt, der sich aufgrund der von einem Spannungsversorger 12 gelieferten Spannung $U = U_o \sin\omega t$ ergibt. Bei einer vorgegebenen Stromstärke $I_o$ und

einer vorgegebenen Wechselstromkreisfrequenz $\omega_1$ bewegt sich der Elektronenstrahl 7' von einer ersten Position I zu einer zweiten Position II und wieder zurück, und zwar im Takt der jeweiligen Wechselstromfrequenz. Der Elektronenstrahl 7' beschreibt also eine Gerade auf der Oberfläche, die zwischen I und II aufgespannt ist. Der Auslenkwinkel $\alpha_1$ rechts von der Mittenachse 16 entspricht hierbei dem Auslenkwinkel $\alpha_1$' links von der Mittenachse 16. Beide Winkel $\alpha_1$, $\alpha_1$' werden von der Stromstärke des jeweils durch die Ablenkeinheit 11 fließenden Wechselstroms bestimmt. Wird die Wechselstromfrequenz bei gleichbleibender Stromstärke vergrößert, so pendelt der Elektronenstrahl 7' theoretisch nach wie vor zwischen den Positionen I und II, jedoch mit einer höheren Frequenz.

In der Praxis ist der Ablenkwinkel $\alpha_1$ bzw. $\alpha_1$' indessen von der Frequenz abhängig, weil eine sogenannte Frequenzdämpfung auftritt. Die frequenzabhängige Dämpfung kommt im wesentlichen durch die Wirbelstromverluste im magnetischen Ablenksystem zustande. Da ein Ablenksystem nicht nur aus Spule besteht, sondern auch Eisen enthält, ergeben sich durch die im Eisen fließenden Wirbelströme frequenzabhängige Rückwirkungen auf den Spulenstrom.

Darüber hinaus kann insbesondere eine nichtlineare Frequenzcharakteristik des die Spulen speisenden Verstärkers zu einer Frequenzabhängigkeit des Spulenstroms führen. Im Ergebnis bedeutet dies, daß bei gleicher Stromstärke, aber erhöhter Frequenz $\omega_2$, der Ablenkungswinkel $\alpha_2$ bzw. $\alpha_2$' kleiner als $\alpha_1$ bzw. $\alpha_1$' ist. Die Differenz zwischen den beiden Winkeln $\alpha_1 - \alpha_2$ wird auch Phasenverschiebung $\Theta$ oder Frequenzdämpfung genannt. Diese Frequenzdämpfung $\Theta$ ist eine Funktion der Wechselstromfrequenz, d. h. $\Theta = f(\omega)$.

Zusätzlich kann eine Phasenverschiebung $\Theta$ auftreten, wenn die Ablenksysteme für die x- und y-Richtung verschieden sind. Mit dieser Phasenverschiebung $\Theta$ ist ein zeitlicher Versatz der Ströme in den für die jeweiligen Ablenkrichtungen x bzw. y verantwortlichen Ablenkspulen gemeint.

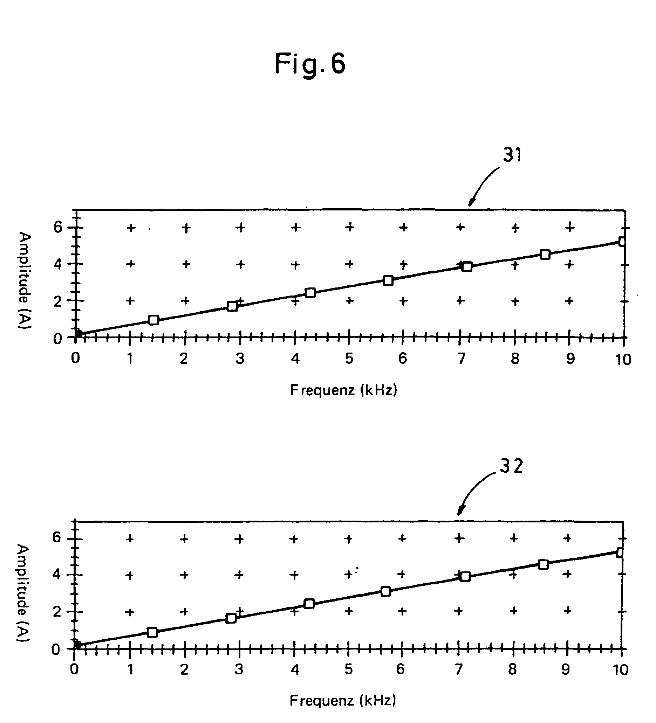

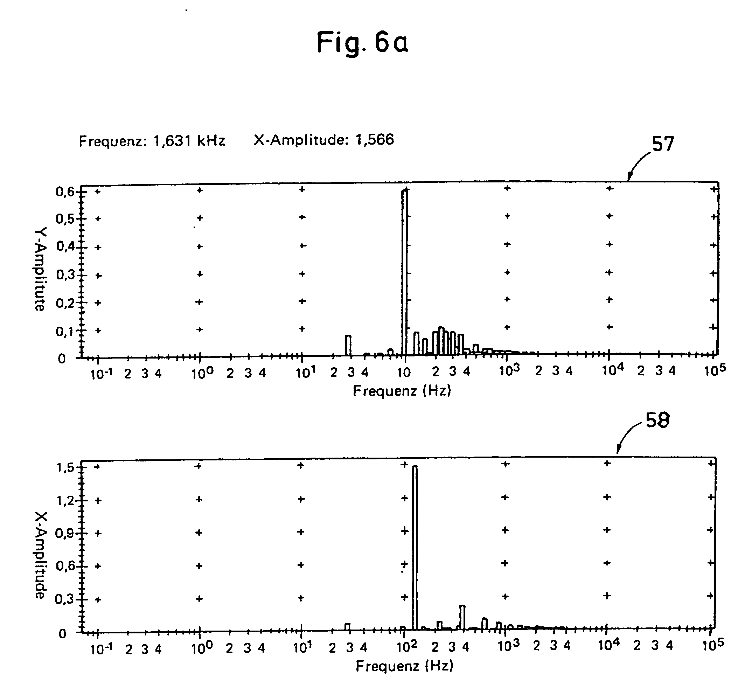

In der Fig. 6 ist in der oberen Darstellung 31 gezeigt, wie sich die Stromamplitude einer Ablenkeinheit in x-Richtung mit zunehmender Frequenz ändern muß, um einen bestimmten Ort mit dem Elektronenstrahl richtig anzusteuern. Die Darstellung 32 zeigt dagegen, wie die Amplitude in y-Richtung mit wachsender Frequenz zunehmen muß, damit ein vorgegebener Punkt richtig angesteuert wird. Es muß also jeweils die Amplitude vergrößert werden, um den Dämpfungsfaktor auszugleichen, der bei zunehmender Frequenz auftritt. Der vorstehend erwähnte funktionale Zusammenhang Amplitude = $f(\omega)$ kann für verschiedene Frequenzen experimentell ermittelt und eingelernt, d. h. in einen Speicher abgespeichert werden. Es genügen für diese Zwecke beispielsweise sechs verschiedene Frequenzen, die beim Einlernen erfaßt werden. Im Gegensatz zu dem Einlernen statischer Ablenkfehler muß der Elektronenstrahl nicht auf verschiedene Punkten $P_1 ... P_{19}$ gerichtet werden, sondern es genügt - bei Betrachtung einer Koordinaten, daß er zwischen zwei Punkten, z. B. $P_9$ und $P_{10}$ pendelt. Bei jeder der sechs Frequenzen wird dann die Amplitude soweit geändert, daß der Elektronenstrahl die Punkte $P_9$ und $P_{10}$ erreicht.

In der Praxis wird dieses Teach-in-Verfahren für zwei Koordinaten durchgeführt. Hierbei wird auf beide Ablenkeinheiten ein sinusförmiger Stromverlauf vorgegeben, wobei die Frequenz variiert wird. Wenn eine Frequenzdämpfung auftritt, verringert sich die Amplitude einer abgebildeten Ellipse bzw. eines abgebildeten Kreises oder einer Linie. Die Stromamplituden für x- und y-Richtung werden nun so nachgeführt, daß wieder die vorgegebene Ablenkamplitude erreicht wird.

Durch die Frequenzdämpfungen müssen indessen nicht nur die Amplituden der die Ablenkeinheiten speisenden Ströme geändert werden, sondern es muß auch eine Korrektur der Kurvenform erfolgen. Wird nämlich auf die Ablenkeinheiten von einer Spannungsquelle ein reiner Sinusstrom gegeben, so ergibt sich aufgrund der dynamischen Fehler eine Verzerrung der Sinusform, d. h. der den Elektronenstrahl tatsächlich ablenkende Strom hat keine reine Sinusform, sondern eine Sinusform mit überlagerten Oberwellen. Um diese verzerrte Sinuskurve reproduzieren zu können, wird eine Fourier-Transformation vorgenommen. Mit Hilfe der Fourier-Transformation läßt sich eine von der Zeit abhängige Funktion in die von der Frequenz abhängige Fourier-Transformierte durchführen und umgekehrt. Die Fourier-Transformation stellt somit eine Operation dar, die aus einer Zeitfunktion eine Funktion im Frequenzbereich erzeugt, also einen Übergang vom Zeit- in den Frequenzbereich bewirkt und umgekehrt. Wird ein in der Zeit ablaufender Strom, der durch die Ablenkeinheiten geschickt wird, Fourier-transformiert, so entstehen mehrere Frequenzen mit unterschiedlichen Amplituden.

In der Fig. 6a sind im oberen Teil 57 die Amplituden oder Fourier-Koeffizienten für die y-Komponente des Ablenkstroms eines Elektronenstrahls dargestellt, während im unteren Teil 58 die Fourier-Koeffizienten der x-Komponente des Ablenkstroms dargestellt sind.

Für eine Transformation vom Zeit- in den Frequenzbereich empfiehlt sich stets dann, wenn Digitalrechner eingesetzt werden, der Einsatz der Schnellen Fourier-Transformation (FFT = Fast-Fourier-Transformation).

Bei der Schnellen-Fourier-Transformation (FFT) handelt es sich um einen Algorithmus für die Berechnung der Fourier-Koeffizienten, der weitaus weniger Rechenaufwand erfordert als die herkömmlichen Berechnungsmethoden (vgl. J. W. Cooley and J. W. Tukey, "An algorithm for the machine calculation of complex Fourier series", Math. of Computer, Vol. 19, pp. 297 - 301, April 1965).

Es handelt sich bei der FFT um ein Verfahren für die effiziente Berechnung der diskreten Fourier-Transformation (DFT) von Zeitfolgen, d. h. von diskreten Datenmustern. Die diskrete Fourier-Transformation (DFT) ist eine eigenständige Transformation, etwa wie die Fourier-Integral-Transformation oder die Fourier-Reihentransformation.

Was die Fourier-Transformation für kontinuierliche Wellen bedeutet, bedeutet die DFT für nach dem Abtasttheorem abgetastete Impulsproben, sog. Nyquist-Proben. Hierdurch ist die DFT besonders nützlich für die Leistungsspektrumsanalyse und für die Filtersimulation mittels Digitalrechnern.

Gleichgültig, ob die normale oder schnelle Fourier-Transformation durchgeführt wird, ist für die vorliegende Erfindung von Bedeutung, daß eine Korrektur im Frequenzbereich erfolgt. Dies bedeutet, daß beim teach-in für bestimmte vorgegebene Frequenzen diejenigen (verzerrten) Ströme, welche auf der Oberfläche des zu verdampfenden Materials das gewünschte Abtastmuster erzeugen, einer Fourier-Transformation unterworfen werden.

In der Fig. 6a ist dies für die Frequenz 1,631 kHz dargestellt, und zwar getrennt für die x- und y-Komponenten des Stroms. Die x-Komponente ist in Feld 57 dargestellt, während die y-Komponente in Feld 58 dargestellt ist. Wird eine rein sinusförmige Frequenz auf die Ablenkungseinheiten gegeben, so muß diese strommäßig korrigiert werden, um das gewünschte Ablenkmuster zu erzeugen. Die Korrektur erfolgt hierbei in der Weise, daß der sinusförmige Verlauf der Frequenz Fourier-transformiert wird und die Fourier-Koeffizienten mittels der FFT entsprechend der beim teach-in ermittelten Werte korrigiert werden. Durch Rücktransformation erhält man dann den korrigierten Stromverlauf I'($\omega$t).

$$I(\omega_T t) = \sum_\ell F_\ell \cdot e^{\ell \cdot i\omega_T t}$$

$$I'(\omega_T t) = \sum_\ell F_\ell' \cdot e^{\ell \cdot i\omega_T t - i\theta(\ell \cdot \omega_T)}$$

$$F'_\ell = F_\ell \cdot \frac{\alpha(I, \omega = 0)}{\alpha(I, \omega = \ell \cdot \omega_T)}$$

wobei

    I = Idealer Strom der Ablenkeinheit
    F = Fourier-Amplitude
    $\ell$ = ganzzahlige Zahl
    I' = korrigierter Strom
    F' = korrigierte Fourier-Amplitude
    $\alpha$ = Ablenkung des Elektronenstrahls

Wenn man den Elektronenstrahl mittels eines Wechselstroms gezielt auf einen Punkt der Oberfläche 15 steuern will, genügt es somit nicht, nur die Stromstärke so einzustellen, daß eine entsprechende Gleichstromstärke die gewollte Auslenkung erzielen würde, sondern es muß die Stromstärke des Wechselstroms so eingestellt werden, daß der Phasen- oder Winkelfehler kompensiert wird. Diese auf reinen Wechselstrom zutreffenden Überlegungen gelten im Prinzip auch für pulsartige Gleichströme.

Neben der Frequenzdämpfung, d. h. der Dämpfung der Ablenk-Amplitude des Elektronenstrahls, kann auch noch, wie oben bereits erwähnt, eine Phasendrehung auftreten. Wenn das Ablenksystem in x- und y-Richtung nicht symmetrisch ist, z. B. aufgrund unterschiedlicher Polschuhabmessungen, kommt es zu einer Phasenverschiebung zwischen diesen beiden Richtungen. Auch diese Phasenverschiebung bzw. dieser Phasenfehler wird erfindungsgemäß korrigiert, und zwar auf folgende Weise.

Bei unterschiedlichen Frequenzen wird wieder ein sinusförmiger Stromverlauf auf die Ablenkung gegeben, so daß auf dem Tiegel eine diagonal verlaufende Linie zustandekommt. Tritt nun eine Phasendrehung auf, entsteht aus dieser Linie eine Ellipse. Manuell wird hierauf bei unterschiedlichen Frequenzen eine Phasendifferenz eingestellt, so daß wieder eine Linie sichtbar wird. Wenn man dies für einige Meßpunkte, z. B. sechs, durchgeführt hat, kann man wiederum durch eine Polynomnäherung eine notwendige Phasenverschiebung für jede beliebige Frequenz berechnen.

Beim Einlernen oder teach-in werden etwa nur sechs verschiedene Frequenzen einer Fourier-Transformation unterworfen. Will man auch für die übrigen Frequenzen korrigierte Stromverläufe durch die Ablenkspulen ermitteln, muß - wie oben bereits angedeutet - ein Interpolationsverfahren herangezogen werden. Dieses besteht z. B. darin, daß der Korrekturfaktor für eine beliebige Frequenz $\omega_q$ nach folgender Formel berechnet wird:

$$\frac{\alpha(I, \omega = 0)}{\alpha(I, \omega = \omega_q)} = \sum_{i=0}^{n} a_{i,\ell} \cdot \omega_q^i$$

worin $\ell$ = x bzw. y

$a_{i,\ell}$ = Koeffizienten, die durch das Teach-in-Verfahren ermittelt wurden

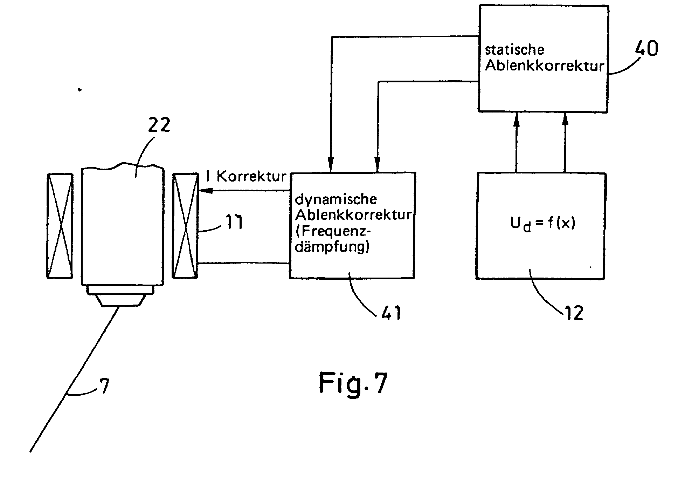

In der Fig. 7 ist eine Prinzipdarstellung für die Durchführung der Erfindung bei einer x-Ablenkung gezeigt. Die von der Spannungsquelle 12 gelieferte Spannung ist hier mit $U_d$ = f(x) bezeichnet, wodurch zum Ausdruck gebracht werden soll, daß der Strom eine beliebige Form haben, also Gleich- oder Wechselstrom sein kann und für die Speisung der x-Ablenkungsspule vorgesehen ist.

Dieser Strom $I_d$ = f(t) der Stromquelle 12 wird sodann mittels einer geeigneten Einrichtung im Block 40 der oben beschriebenen statischen Ablenkungsfehlerkorrektur unterworfen. Das hieraus resultierende Ergebnis wird entsprechend dem oben erläuterten Verfahren in einer Einrichtung 41 einer dynamischen Frequenzdämpfungs-Korrektur unterworfen. Der auf diese Weise korrigierte Strom bewirkt, daß der Elektronenstrahl 7 exakt die x-Koordinate trifft, die er treffen soll.

Wie sich aus dem Vorstehenden ergibt, werden bei der Erfindung zunächst geometrische x-,y-Daten vorgegeben, welche die Punkte bezeichnen, die von dem Elektronenstrahl erfaßt werden sollen. Dies kann beispielsweise eine Kreis- oder Ellipsenfläche sein. Sodann werden diese Koordinaten korrigierten Stromwerten zugeordnet, welche die Ablenkfehler korrigieren. Anstelle der Eingabe von Raumkoordinaten in einen Rechner ist es auch möglich, die Leistungsverteilungen, die ein Elektronenstrahl auf einer Oberfläche erzeugen soll, direkt einzugeben. Anschließend wird der so ermittelte Stromverlauf vom Zeitbereich in den Frequenzbereich transformiert und in diesem Frequenzbereich korrigiert, indem die Amplituden der einzelnen Oberwellen korrigiert werden, d. h. es werden Amplituden der höheren Frequenzanteile relativ stärker erhöht als die Amplituden der niedrigen Frequenanteile. Daraufhin wird das korrigierte Frequenzspektrum wieder in den Zeitbereich zurücktransformiert, so daß sich ein korrigierter Stromverlauf ergibt.

Für diese direkte Leistungsverteilungseingabe stellt die statische und dynamische Fehlerkorrektur eine Voraussetzung dar. Wurde keine Fehlerkorrektur vorgenommen, kann auch nicht die vorgegebene Leistungsverteilung reproduziert werden.

Auf die Vorgabe und Durchführung der Leistungsverteilung wird im folgenden näher eingegangen.

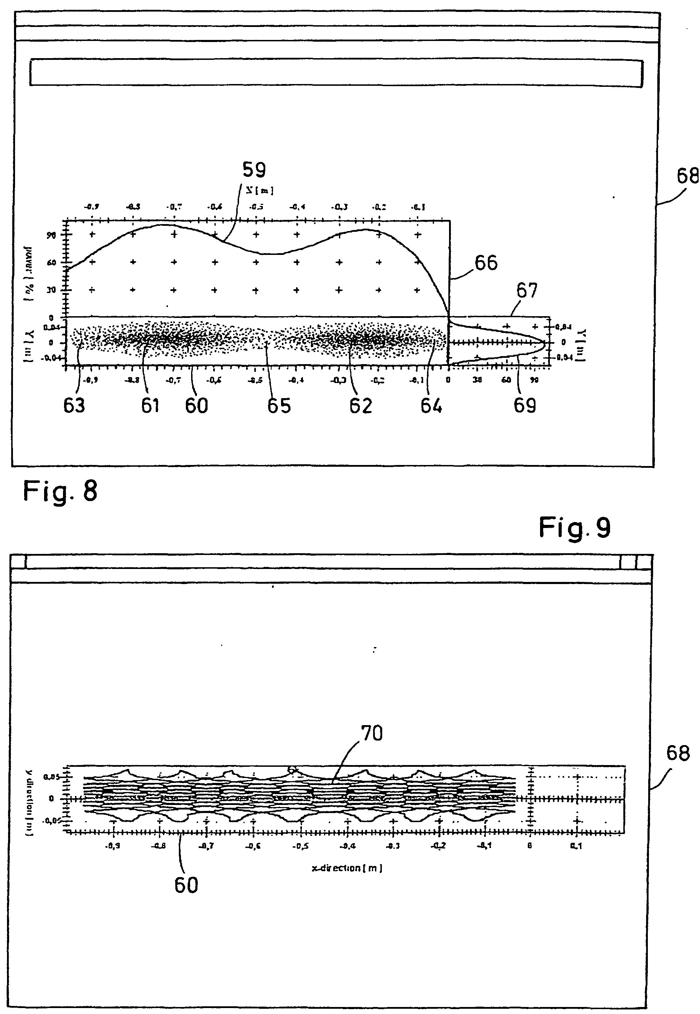

In der Fig. 8 ist ein rechteckiger Tiegel 60 gezeigt, bei dem die tiefgeschwärzten Felder 61, 62 eine große Elektronenstrahlauftreffleistung darstellen, während die weniger stark geschwärzten Felder 63, 64, 65 eine geringere Elektronenstrahlauftreffleistung darstellen.

Der Tiegel 60 hat beispielsweise eine Länge von einem Meter und eine Breite von ca. 10 cm. Der Tiegel 60 ist zusammen mit den Rasterfeldern 66, 67 auf einem Computer-Bildschirm 68 dargestellt. Mit Hilfe von Lichtgriffeln oder dergleichen kann die gewollte Leistungsverteilung 68 in x-Richtung sowie die gewollte Leistungsverteilung 69 in y-Richtung eingegeben werden.

Gemäß der Erfindung wird diese Leistungsverteilung automatisch hergestellt. Dies geschieht dadurch, daß der Weg des Elektronenstrahls automatisch und unter Berücksichtigung der vorerwähnten Fehlerkorrekturen berechnet wird. Das Ergebnis dieser Berechnung ist in der Fig. 9 dargestellt, wo man den Weg 70 des Elektronenstrahls erkennt. Die Leistungsverteilung auf dem rechteckigen Tiegel 60 wird somit über ein Längs- und ein Querprofil $P_x(x)$, $P_y(y)$ vorgegeben. Die Leistungsverteilung auf dieser Fläche ergibt sich dann aus der Multiplikation

$$P(\vec{r}) = P_x(x) \cdot P_y(y); \ \vec{r} = \{x, y\}$$

In ähnlicher Weise kann man vorgehen, wenn es sich statt um einen rechtwinkligen um einen runden Tiegel handelt.

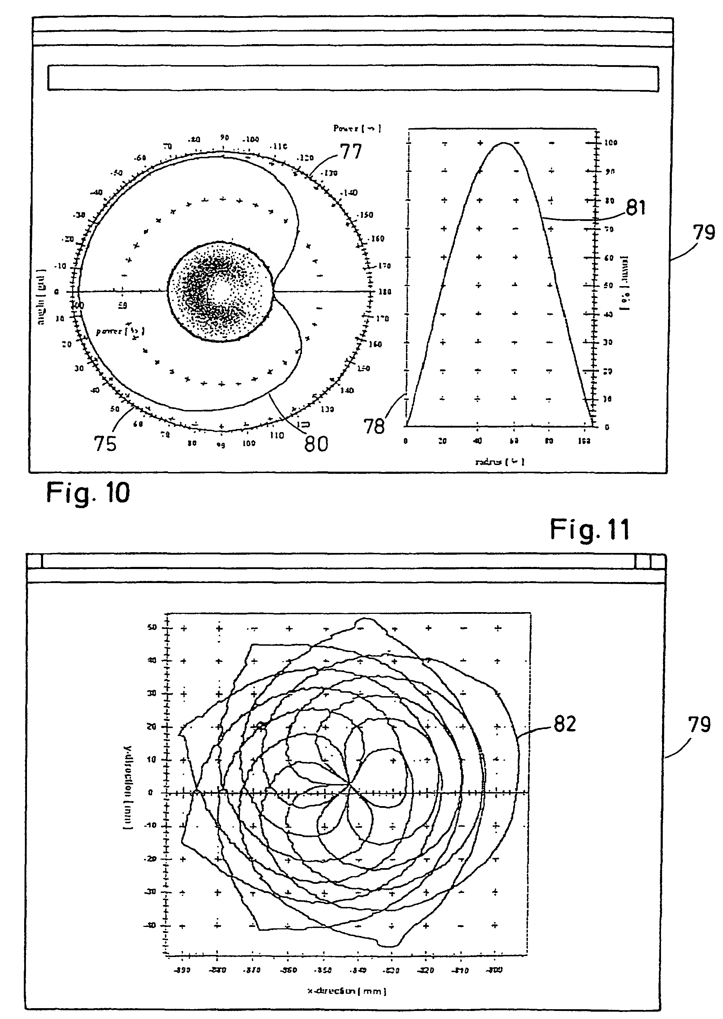

In der Fig. 10 ist ein runder Tiegel 75 mit einer bestimmten Soll-Leistungsverteilung gezeigt. Dieser Tiegel 75 ist zusammen mit Polarkoordinaten 77 und einer Radius-Leistungs-Ebene 78 auf einem Bildschirm 79 dargestellt. Mittels eines Lichtgriffels oder anderer geeigneter Maßnahmen können nun die Kurven 80, 81 vorgegeben werden, wodurch auch die Leistungsverteilung des Tiegels festgelegt ist.

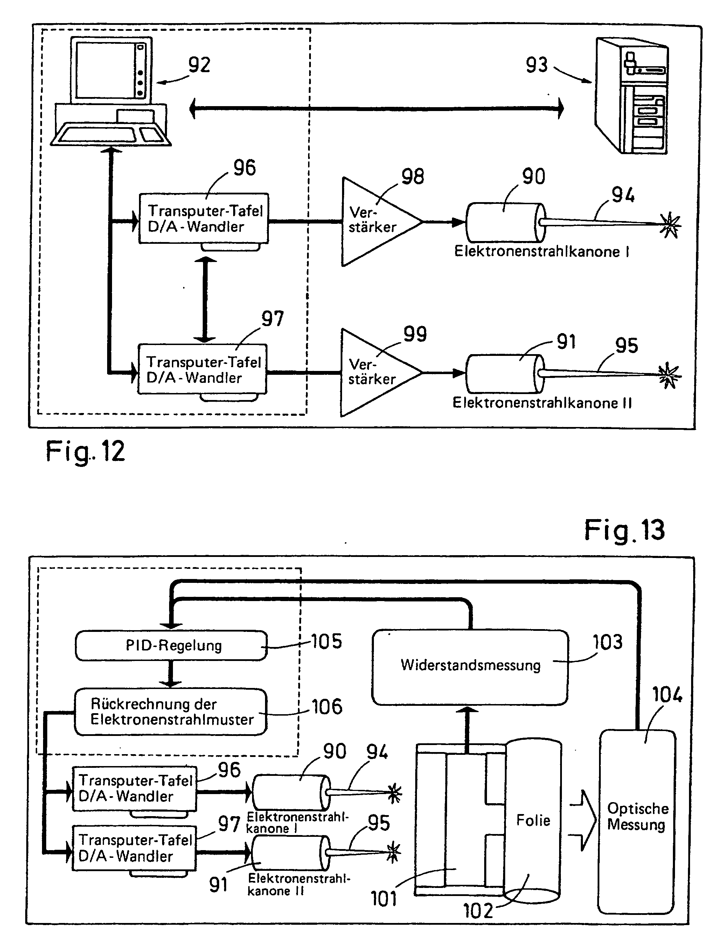

In der Fig. 11 ist der Weg 82 des Elektronenstrahls dargestellt, welcher der in der Fig. 10 gezeigten Leistungsverteilung zugeordnet ist. Im Falle des runden Tiegels 75 wird eine radiale und eine azimuthale Leistungsverteilung $P_r(r)$, $P_\phi(\phi)$ vorgegeben. Die resultierende Leistungsverteilung ergibt sich dann aus

$$P(\vec{r}) = P_r(r) \cdot P_\Phi(\Phi))$$

wobei

$$\vec{r} = \{r \cdot \cos(\Phi), \, r \cdot \sin(\Phi)\}$$

Die Frequenzen $\omega_x$, $\omega_y$ bzw. $\omega_r$, $\omega_\Theta$ der Ablenkströme sind im Prinzip frei wählbar. Über die geeignete Wahl der Frequenzdifferenz kann die Auflösung und Form des Ablenkmusters beeinflußt werden. Über die Phasen $\rho_x$, $\rho_y$ bzw. $\rho_r$, $\rho_\Theta$ wird der Start- bzw. Endpunkt des Strahlweges definiert. Gemittelt über die Zeit $T = 1/\omega$ ergibt sich unabhängig von der Wahl der Frequenzen und Phasen das oben definierte Leistungsprofil.

Insbesondere kann die Frequenzdifferenz klein gewählt werden, wobei gleichzeitig ein Ablenkmuster erzeugt werden kann, das eine hohe Auflösung zeigt. Damit sind die Ablenkfrequenzen in horizontaler und vertikaler Richtung ähnlich. Dieses reduziert die Anforderung an das Ablenksystem bezüglich Übertragungseigenschaft hoher Frequenzen (Gegenbeispiel Fernsehtechnik: Die Zeilenfrequenz (Horizontalablenkung) ist hier wesentlich größer als die Bildfrequenz (Vertikalablenkung)).

In der Fig. 12 ist ein Blockschaltbild für die Ansteuerung zweier Elektronenstrahlkanonen 90, 91 mittels eines Computers 92 dargestellt. Dieser Computer 92 kann mit einer Steuereinheit 93 kommunizieren. Die Elektronenstrahlkanonen 90, 91 erzeugen jeweils einen Elektronenstrahl 94, 95, dessen Lage und Intensität vom Computer 92 vorgegeben werden. Von diesem Computer 92 werden Signale auf Transputer mit D/A-Wandlern 96, 97 gegeben, die ihrerseits jeweils einen Verstärker 98, 99 ansteuern, von dem jeder mit einer der beiden Elektronenstrahlkanonen 90, 91 verbunden ist. Unter einem Transputer versteht man einen 32-Bit-Chip und -Computer, der von der britischen Firma INMOS entwickelt wurde und vor allem zur parallelen, d. h. gleichzeitigen Verarbeitung umfangreicher Datenmengen dient. Einem üblichen Mikroprozessor sind hierbei vier Kommunikationseinheiten zur Seite gestellt, die auch während der Rechentätigkeit des Prozessors je zehn MegaByte Daten übertragen können. Damit sind rechenintensive Aufgaben in sehr kurzer Zeit zu bewältigen.

Die Fig. 13 zeigt einen geschlossenen Regelkreis für eine erfindungsgemäße Einrichtung. Mit 101 ist hierbei ein Tiegel bezeichnet, dessen Verdampfungsprodukte auf eine gerollte Folie 102 gelangen. Die von dem Tiegel 101 bzw. der Folie 102 mittels Meßeinrichtung 103, 104 abgegriffenen Meßdaten, z. B. elektrische Widerstandswerte oder optische Transmissionsgrade, werden auf einen PID-Regler 105 gegeben, dessen Steuersignale in einer Einrichtung 106 auf Elektronenstrahl-Ablenkmuster umgerechnet und auf die Transputer 96, 97 gegeben werden, welche die Elektronenstrahlkanonen 90, 91 ansteuern.

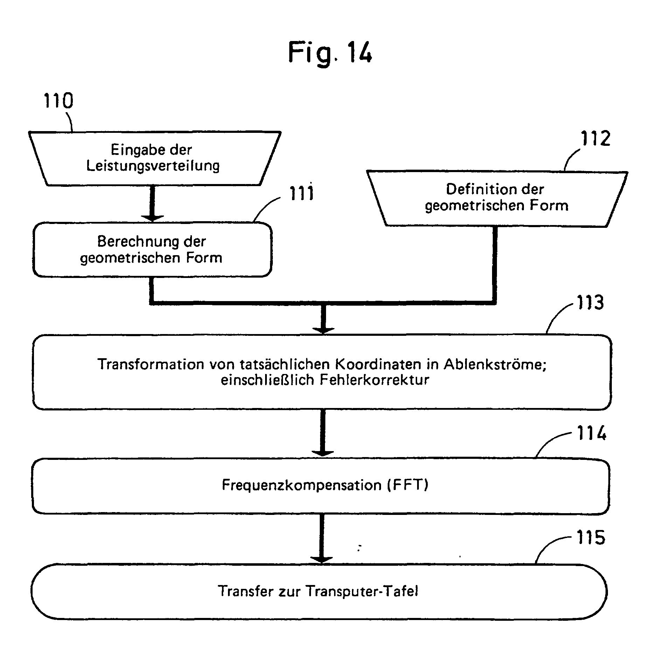

In der Fig. 14 sind die wesentlichen Schritte bei der Realisierung der Erfindung angegeben. Es ist möglich, entweder eine Leistungsverteilung oder ein geometrisches Muster vorzugeben. Wird bei Block 112 ein geometrisches Muster, beispielsweise Kreis, Ellipse etc., für einen Elektronenstrahl vorgegeben, so werden die räumlichen Koordinaten bei 113 in Ablenkströme mit statischer Korrektur transformiert. Diese statisch korrigierten Ablenkströme werden dann bei 114 einer dynamischen Frequenzkorrektur unterworfen. Das rücktransformierte Ergebnis wird dann bei 115 zum Transputer gegeben.

Auf der linken Seite der Fig. 14 ist dargestellt, daß bei 110 anstelle eines geometrischen "pattern" eine Leistungsverteilung vorgegeben wird. Aus dieser Leistungsverteilung wird bei 111 die geometrische Form berechnet. Der weitere Ablauf ist dann der gleiche wie bei dem vorgegebenen geometrischen Muster.

**Patentansprüche**

1. Verfahren für den Betrieb eines Hochleistungs-Elektronenstrahls, der für das Verdampfen oder Schmelzen von Materialien in einem Tiegel oder dergleichen verwendet wird, enthaltend folgende Schritte:

    Bereitstellen wenigstens einer Ablenkeinheit für den Elektronenstrahl, die Ablenkfehler aufweist;

    Auswählen von geometrischen Koordinaten $(x, y; r, \varphi)$ von wenigstens zwei Punkten auf der Oberfläche des zu verdampfenden oder zu schmelzenden Materials;

    Korrektur der den ausgewählten Punkt-Koordinaten $(x, y; r, \varphi)$ zugeordneten Ablenkströme $(I_x, I_y; I_r, I_\varphi)$ im statischen Betrieb des Elektronenstrahls durch Änderung der Stromamplituden in einem Einlernvorgang und Berechnung der korrigierten Ablenkströme für dazwischen liegende Punkte auf einem vorgegebenen Weg des Elektronenstrahls durch Interpolation mittels der Methode der kleinsten Fehlerquadrate;

Korrektur der den Punkt-Koordinaten (x, y; r, $\varphi$) des Elektronenstrahl-Wegs zugeordneten Ablenkströme ($I_x$, $T_y$; $I_r$ $I_\varphi$) im dynamischen Betrieb des Elektronenstrahls durch von der Frequenz der Ablenkströme abhängige Änderung der Stromamplituden in einem weiteren Einlernvorgang, wobei der Elektronenstrahl zwischen zwei vorgegebenen Markierungspunkten auf der Oberfläche des zu verdampfenden oder zu schmelzenden Materials hin und her abgelenkt wird, die Frequenz dieser Ablenkung geändert wird und die Amplitude des Ablenkstroms dabei so verändert wird, dass der Elektronenstrahl jeweils die vorgegebenen Markierungspunkte erreicht;

Zuführen der korrigierten Ablenkströme auf die wenigstens eine Ablenkeinheit; Führen des Elektronenstrahls mit der wenigstens einen Ablenkeinheit mit einer vorgebbaren variablen Geschwindigkeit und einer bestimmten Intensität über die Oberfläche des zu verdampfenden oder zu schmelzenden Materials.

2. Verfahren nach Anspruch 1 mit den zusätzlichen Schritten:

Festlegen einer Leistungsverteilung auf der Oberfläche des zu verdampfenden und zu schmelzenden Materials;

Zuordnen geometrischer Koordinaten (x, y; r, $\varphi$) zu der Leistungsverteilung auf der Oberfläche des zu verdampfenden oder zu schmelzenden Materials.

3. Verfahren nach Anspruch 1 oder 2 mit den zusätzlichen Schritten, Fourier-Transformation und Darstellung der nicht korrigierten Ablenkströme als Fourier-Reihe,

$$I(\omega_T t) = \sum_\ell F_\ell \cdot e^{\ell \cdot i \omega_T t}$$

wobei

$F_\ell$ = Fourier-Amplitude
$\omega_T$ = Kreisfrequenz
$\ell$ = eine ganze Zahl größer oder gleich 1,
t = Zeit,

Definition der von dynamischen Fehlern korrigierten Ablenkströme durch die Fourier-Reihe

$$I'(\omega_T t) = \sum_\ell F_\ell' \cdot e^{\ell \cdot i \omega_T t - i \theta(\ell \, \omega_T)}$$

wobei

$$F_\ell' = F_\ell \cdot \frac{\alpha(I, \omega = 0)}{\alpha(I, \omega = \ell \cdot \omega_T)}$$

wobei

$\alpha$ (I,$\omega$ = 0) der Ablenkwinkel bei Gleichstromablenkung des Elektronenstrahls und
$\alpha$ (I,$\omega$ = $\ell \cdot \omega_T$) der Ablenkwinkel bei Wechselstromablenkung des Elektronenstrahls ist.

**Claims**

1. A method for operating a high power electron beam, which is used for the vaporisation or fusion of materials in a crucible or suchlike, comprising the following steps:

making available at least one deflection unit for the electron beam, said deflection unit having deflection errors;

selection of geometrical coordinates (x, y; r, φ) of the least two points on the surface of the material to be vaporised or fused;

correction of the deflection currents ($I_x$, $I_y$; $I_r$, $I_φ$) assigned to the selected point coordinates (x, y; r, φ) in the static operation of the electron beam by a change of the current amplitudes in a teach-in procedure and calculation of the corrected deflection currents for points lying between on a predetermined path of the electron beam by interpolation by means of the method of smallest error squares;

correction of the defection currents ($I_x$, $I_y$; $I_r$, $I_φ$) assigned to the selected point coordinates (x, y; r, φ) of the electron beam path in the dynamic operation of the electron beam by a change of the current amplitudes in a further teach-in procedure, said change being dependent on the frequency of the deflection currents, whereby the electron beam is deflected to and fro between two predetermined marking points on the surface of the material to be vaporised or fused, the frequency of this deflection is changed and the amplitude of the deflection current is thereby changed in such a way that the electron beam reaches the predetermined marking points in each case;

feeding of the corrected deflection currents to the at least one deflection unit;

guiding of the electron beam with the at least one deflection unit at a predeterminable variable speed and with a specified intensity over the surface of the material to be vaporised or fused.

2. The method according to claim 1 with the additional steps:

establishment of a power distribution on the surface of the material to be vaporised or fused;

assignment of geometrical coordinates (x, y; r, φ) to the power distribution on the surface of the material to be vaporised or fused.

3. The method according to claim 1 or 2 with the additional steps,
Fourier transform and representation of the uncorrected deflection currents as a Fourier series,

$$I(\omega_T t) = \Sigma_l F_l \cdot e^{l \cdot i \omega_T t}$$

whereby

$F_l$ = Fourier amplitude
$\omega_T$ = angular frequency
l = a whole number greater than or equal to 1
t = time

definition of the deflection currents corrected for dynamic errors by the Fourier series

$$I'(\omega_T t) = \Sigma_l F'_l \cdot e^{l \cdot l \omega_T t - i \theta (l \cdot \omega_T)}$$

whereby

$$F'_l = F_l \cdot \frac{\alpha(l, \omega=0)}{\alpha(l, \omega = l \cdot \omega_T)}$$

whereby

α (l, ω = 0) is the deflection angle with direct-current deflection of the electron beam and

α (l, ω = l · $\omega_T$) is the deflection angle with alternating-current deflection of the electron beam.

**Revendications**

1. Procédé pour le fonctionnement d'un faisceau d'électrons de grande puissance qui est utilisé pour l'évaporation ou la fonte de matériau dans un creuset ou similaire, comportant les étapes suivantes:

   mise à disposition d'au moins une unité de déviation pour le faisceau d'électrons qui présente une erreur de déviation;

   sélection de coordonnées géométriques (x, y; r, $\varphi$) d'au moins deux points sur la surface du matériau à évaporer ou à fondre,

   correction des courants de déviation ($I_x$, $I_y$; $I_r$, $I_\varphi$) associés aux coordonnées de points sélectionnées (x, y; r; $\varphi$) en fonctionnement statique du faisceau d'électrons par modification des amplitudes de courant dans une opération d'apprentissage et calcul des courantws de déviation pour les points se trouvant entre sur une trajectoire prédéterminée du faisceau d'électrons par interpolation au moyen de la méthode des plus petits carrés d'erreur;

   correction des courants de déviation ($I_x$, $I_y$; $I_r$, $I_\varphi$) associée aux coordonnées de points (x, y; r, $\varphi$) du trajet de faisceau d'électrons en fonctionnement dynamique du faisceau d'électrons par modification des amplitudes de courant dépendant de la fréquence des courants de déviation dans une autre opération d'apprentissage, le faisceau d'électrons étant dévié entre deux points prédéterminés de marquage sur la surface du matériau à évaporer ou à fondre, la fréquence de cette déviation étant modifiée et l'amplitude du courant de déviation étant modifiée de sorte que le faisceau d'électron atteint respectivement les points de marquage prédéterminés;

   amenée des courants corrigés de déviation à au moins une unité de déviation;

   passage du faisceau d'électrons sur la surface du matériau à évaporer ou à fondre avec au moins l'unité de déviation à une vitesse prédéterminable variable et à une certaine intensité.

2. Procédé selon la revendication 1 avec les étapes supplémentaires :

   détermination d'une répartition de puissance sur la surface du matériau à évaporer ou à fondre,

   association de coordonnées géométriques (x, y; r, $\varphi$) à la répartition de puissance sur la surface du matériau à évaporer ou à fondre.

3. Procédé selon la revendication 1 ou 2, avec les étapes supplémentaires
   transformation de Fourier et représentation des flux de déviation non corrigés en tant que série de Fourier

$$I(\omega_T t) = \Sigma_l F_l \cdot e^{l \cdot i\omega_T t}$$

   où

   $F_l$ = amplitude Fourier
   $\omega_T$ = fréquence angulaire
   l = un nombre entier supérieur ou égal à 1,
   t = le temps

   définition des courants de déviation corrigés par des erreurs dynamiques par la série de Fourier

$$I'(\omega_T l) = \Sigma_l F'_t \cdot e^{l - i\omega_T t - i\theta(l - \omega_T)}$$

   où

$$F'_I = F_I \cdot \frac{\alpha(I, \omega=0)}{\alpha(I, \omega=I \cdot \omega_T)}$$

où
$\alpha$ (I, $\omega$ = 0) est l'angle de déviation pour une déviation de courant continu du faisceau d'électrons et
$\alpha$ (I, $\omega$ = I·$\omega_T$) est l'angle de déviation pour une déviation de courant alternatif du faisceau d'électrons.

Fig. 1

Fig. 2

Fig. 3

Ablenkung

Fig. 4

# Fig. 5

$I = I_0 \sin \omega t$

11

12

22

$\alpha_1'$  $\alpha_1$

$\Theta$  $\Theta$

$\alpha_2'$  $\alpha_2$

$\omega_1$  $\omega_1$

7'  7'

16

$\omega_2$  $\omega_2$

II  C  I

# Fig. 6

# Fig. 6a

Frequenz: 1,631 kHz    X-Amplitude: 1,566

statische
Ablenkkorrektur                    40

22

I Korrektur

dynamische
Ablenkkorrektur
(Frequenzdämpfung)                          $U_d = f(x)$

11

7                                  41            12

**Fig. 7**

Fig. 8

Fig. 9

Fig. 10

Fig. 11

## Fig. 12

Transputer-Tafel D/A-Wandler — 96

Ver-stärker — 98

Elektronenstrahlkanone I — 90

94

92

93

Transputer-Tafel D/A-Wandler — 97

Ver-stärker — 99

Elektronenstrahlkanone II — 91

95

## Fig. 13

PID-Regelung — 105

Rückrechnung der Elektronenstrahlmuster — 106

Widerstandsmessung — 103

104

Transputer-Tafel D/A-Wandler — 96

Elektronenstrahl-kanone I — 90 94

Transputer-Tafel D/A-Wandler — 97

Elektronenstrahl-kanone II — 91 95

Folie

Optische Messung

101

102

## Fig. 14

110

| Eingabe der Leistungsverteilung |

111

| Berechnung der geometrischen Form |

112

| Definition der geometrischen Form |

113

| Transformation von tatsächlichen Koordinaten in Ablenkströme; einschließlich Fehlerkorrektur |

114

| Frequenzkompensation (FFT) |

115

| Transfer zur Transputer-Tafel |